# EUROPEAN PATENT APPLICATION

(11) **EP 1 993 153 A1**
(43) Date of publication of application: **19.11.2008**
(21) Application number: 08007398.4
(22) Date of filing: 15.04.2008
(51) Int. Cl.: H01L 39/24

(54) **Nb3Sn superconducting wire, precursor of same, and method for producing precursor**

(30) Priority: 16.05.2007 JP 2007130996
(71) Applicant: Kabushiki Kaisha Kobe Seiko Sho, Chuo-ku Kobe-shi Hyogo 651-8585 (JP)
(72) Inventor: Kato, Hiroyuki, Kobe-shi Hyogo 651-2271 (JP); Hase, Takashi, Kobe-shi Hyogo 651-2271 (JP); Zaitsu, Kyoji, Kobe-shi Hyogo 651-2271 (JP)
(74) Representative: Müller-Boré & Partner Patentanwälte

(57) **Abstract**

A precursor for producing a Nb₃Sn superconducting wire includes a bundle of single-element wires each including a Cu or Cu-based alloy matrix, Nb or Nb-based alloy filaments, at least one Sn or Sn-based alloy core, the Nb or Nb-based alloy filaments and at least one Sn or Sn-based alloy core being arranged in the Cu or Cu-based alloy matrix, an diffusion barrier layer around the periphery of the Cu or Cu-based alloy matrix, the inner diffusion barrier layer being composed of Nb or a Nb-based alloy, and a Cu or Cu-based alloy layer around the periphery of the diffusion barrier layer; an outer diffusion barrier layer around the periphery of the bundle of the single-element wires, the outer diffusion barrier layer being composed of Nb, a Nb-based alloy, Ta, a Ta-based alloy, or a combination thereof; and a stabilizing copper layer around the periphery of the outer diffusion barrier layer.

## Description

The present invention relates to a precursor for producing a Nb₃Sn superconducting wire by an internal Sn process, a Nb₃Sn superconducting wire produced by the precursor, and a method for producing the precursor. In particular, the present invention relates to a Nb₃Sn superconducting wire useful as a material of a superconducting magnet, a precursor therefor, and a method for producing the precursor.

In fields in which superconducting wires have been practically used, there are superconducting magnets used for high-resolution nuclear magnetic resonance (NMR) spectrometers, nuclear fusion devices, and accelerators. As a superconducting wire used for superconducting magnets, a Nb₃Sn wire has been practically used and is mainly produced by a bronze process. In the bronze process, a plurality of core materials composed of Nb or a Nb-based alloy are embedded in a Cu-Sn-based alloy (bronze) matrix to form a composite wire. The composite wire undergoes a reduction process such as extrusion or wire drawing, so that the core materials are thinned down to form filaments (hereinafter referred to as "Nb-based filaments"). A plurality of the composite wires each including the Nb-based filaments and the bronze matrix are bundled to form a wire group and then coated with copper for stabilization (stabilizing copper). The wire group further undergoes the reduction process. The resulting wire group is subjected to heat treatment at about 600°C to about 800°C (diffusion heat treatment), so that Nb₃Sn compound layers are each produced at the boundary between the Nb-based filaments and the bronze matrix.

However, the bronze process is disadvantageous in that the solid solubility of Sn in bronze has a limit (15.8% by mass or less), so that the Nb₃Sn compound layers each have a relatively small thickness, and crystallinity deteriorates, thus not achieving a high critical current density Jc. In a superconducting magnet (hereinafter, also referred to as "NMR magnet"), a high critical current density results in a reduction in the size of the NMR magnet, thus reducing the cost of the magnet. Furthermore, the area of the superconducting portion in the conductor can also be reduced, thus reducing the cost of the wire.

As a method of producing a Nb₃Sn superconducting wire other than the bronze process, an internal Sn process is known. Unlike the bronze process, the internal Sn process has no limit in terms of the Sn concentration due to a solid solubility limit. Therefore, the Sn concentration can be set as high as possible, which enables the production of a Nb₃Sn layer of high quality, thereby obtaining a high critical current density Jc. In the wire produced by the bronze process described above, annealing must be performed many times because work hardening of the Cu-Sn alloy occurs during cold working. The internal Sn process does not substantially require annealing. Thus, the delivery time can be shortened. Therefore, there has been a demand for the application of a superconducting wire produced by the internal Sn process (hereinafter, also referred to as a "Nb₃Sn superconducting wire by the internal Sn process") to the NMR magnet.

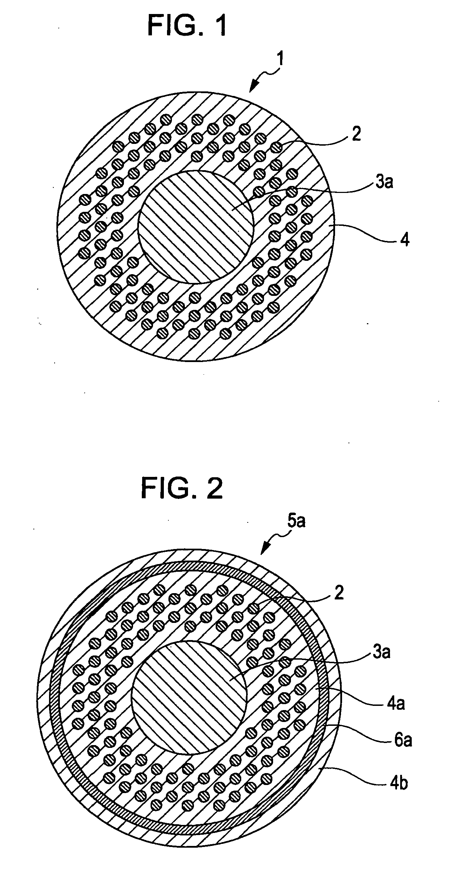

In the internal Sn process, as shown in Fig. 1 (a schematic view of a precursor for producing a Nb₃Sn superconducting wire), a core composed of Sn or a Sn-based alloy (hereinafter, also referred to as a "Sn-based metal core") 3a is embedded in the center of a Cu or Cu-based alloy matrix (hereinafter, also referred to as a "Cu matrix") 4. In the Cu matrix 4 surrounding the Sn-based metal core 3a, a plurality of core materials composed of Nb or a Nb-based alloy (hereinafter, also referred to as "Nb-based metal filaments") 2 are arranged so as to be spaced from each other, thereby preparing a precursor (a precursor for producing a superconducting wire) 1. The precursor undergoes a wire drawing process and then a heat treatment (diffusion heat treatment), so that Sn in the Sn-based metal core 3a is diffused and reacts with the Nb-based filaments 2, thereby producing a Nb₃Sn phase in the wire(for example, see Japanese Unexamined Patent Application Publication No. 49-114389).

As shown in Fig. 2, such a precursor generally has a structure of a precursor 5a that includes a Cu matrix 4a where the Nb-based metal filaments 2 and the Sn-based metal core 3a are arranged, a stabilizing copper layer 4b arranged outside the Cu matrix 4a, and a diffusion barrier layer 6a arranged between the Cu matrix 4a and the stabilizing copper layer 4b. The diffusion barrier layer 6a is, for example, a Nb layer, a Ta layer, or a double layer including a Nb layer and a Ta layer, and serves to prevent the Sn in the Sn-based metal core 3a from diffusing outside during the diffusion heat treatment, thereby enhancing the purity of Sn in the superconducting wire.

The above-described precursor for producing a superconducting wire is produced by the following steps: Nb-based filaments are inserted into a Cu matrix tube, and the reduction process such as extrusion or wire drawing is performed to form a complex (generally having a hexagonal section) which is then cut into a proper length. A plurality of the complexes are filled into a billet which includes a Cu outer cylinder and is provided with or without the diffusion barrier layer 6a. A Cu matrix (Cu solid billet) is disposed in the center of the billet and extrusion is performed. The Cu matrix in the center is mechanically drilled to prepare a cylindrical complex. Alternatively, a hollow billet which includes a Cu outer cylinder and a Cu inner cylinder and is provided with or without the diffusion barrier layer 6a is filled with a plurality of the above complexes (between the outer cylinder and the inner cylinder). Then, hollow extrusion is performed to prepare a cylindrical complex.

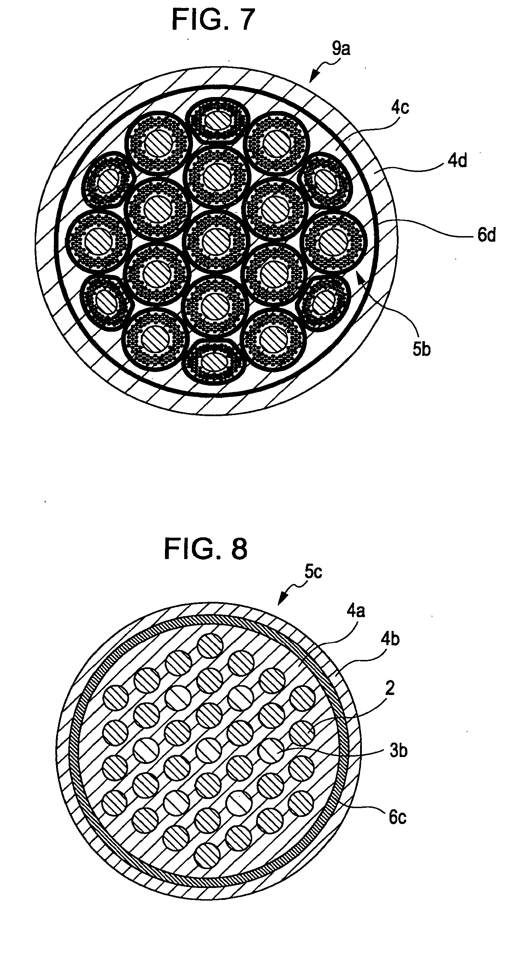

In the gap formed in the center of the cylindrical complex prepared by the above-described process, the Sn-based metal core Sn 3a is inserted and subjected to the reduction process, thereby producing a precursor element including the Nb-based metal filaments 2 and the Sn-based metal core 3a shown in Figs. 1 and 2. Hereinafter, the precursor element may be referred to as a "single-element wire". While Figs. 1 and 2 each show a structure including one single Sn-based metal core 3a, the structure of the single-element wire is not limited thereto. For example, the single-element wire may have a structure including a plurality of the Sn-based metal cores 3a (see Fig. 8 shown below).

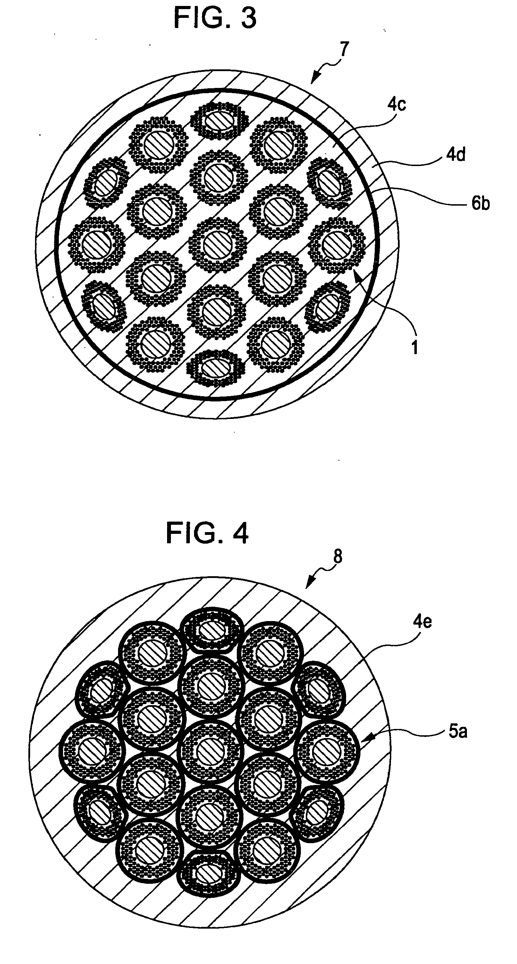

In the case where the precursor prepared as described above is the single-element wire shown in Fig. 1, an assembly including a plurality of the precursors is filled into a Cu matrix tube provided with a diffusion barrier layer 6b (see Fig. 3 described below). In the case where the precursor prepared as described above is the single-element wire shown in Fig. 2, a plurality of the precursors are filled into a Cu matrix tube that is not provided with a diffusion barrier layer. In both cases, subsequently, a reduction process is performed to form a precursor for producing a multi-core superconducting wire (hereinafter, may be referred to as a "multi-element wire").

Figs. 3 and 4 illustrate examples of the multi-element wire. Fig. 3 illustrates a multi-element wire 7 in which an assembly of a plurality of the precursors 1 (single-element wire) shown in Fig. 1 is embedded in a Cu matrix 4c provided with the diffusion barrier layer 6b and a stabilizing copper layer 4d and serves as a superconducting matrix portion (for example, "Teion Kougaku", vol. 39, No. 9, 2004, pp. 391-397). Fig. 4 illustrates a multi-element precursor 8 in which an assembly of a plurality of the precursor 5a (single-element wire) shown in Fig. 2 is embedded in a Cu matrix 4e that does not have a diffusion barrier layer and serves as a superconducting matrix portion (for example, see "IEEE Transaction on Magnetics", Vol. MAG-19, No. 3, MAY 1983 pp. 1131-1134).

A superconducting magnet used for an NMR spectrometer needs to have a significantly stable magnetic field. That is, the superconducting magnet needs to have a time rate of change in magnetic field (attenuation rate) of 0.01 ppm/h or less. Thus, the superconducting magnet needs to operate in a "persistent current mode", in which supercurrent flows permanently in a loop. Actually, a plurality of superconducting coils are connected to form such a magnet. To achieve the persistent current mode, a superconducting state needs to be maintained also at the connection between the superconducting wires of the coils. Thus, it is necessary to expose and connect Nb₃Sn superconducting filaments to each other at a position of the connection without a diffusion barrier layer, composed of a Nb-based metal or a Ta-based metal, which is in a normal conducting state when a magnetic field experienced is about 0.5 T.

Nb₃Sn superconducting wires prepared by the bronze process are categorized into an "externally stabilized wire", in which a stabilizing copper layer and a diffusion barrier layer are arranged outside a superconducting matrix portion as described above, and an "internally stabilized wire", in which a stabilizing copper layer and a diffusion barrier layer are arranged inside a superconducting matrix portion. The externally stabilized wire is generally used because it has further excellent critical current density (Jc) properties. In such wires, superconducting filaments can be exposed, and a method of forming a superconducting connection between the filaments is established.

In contrast, in the case where the Nb₃Sn superconducting wires by the internal Sn process has the structure shown in Fig. 3, diffusion heat treatment after the removal of the diffusion barrier layer 6b allows Sn in the single-element wires 1 to diffuse throughout the entire wire, thereby forming Cu-Sn alloy phases each having a high Sn content exceeding 38% by mass, i.e., the ε phase and the η phase. The Cu-Sn alloy phases each having a high Sn content are readily oxidized even by heat treatment in vacuum, so that the Nb-based metal filaments 2 inside thereof are also readily oxidized. Thus, the Nb₃Sn phase is not readily formed, which makes the formation of the superconducting connection difficult.

In the structure shown in Fig. 4, in the case where the diffusion barrier layer 6a (see Fig. 2) is composed of a Ta or a Ta-based alloy, a Ta-Sn compound formed by reaction of Ta or the Ta-based alloy and Sn is in a normal conduction state at a magnetic field of 0.5 T, thus resulting in the occurrence of connection resistance. Even if the diffusion barrier layer 6a is composed of Nb or a Nb-based alloy, the diffusion barrier layer 6a does not completely react with the Nb₃Sn phase and thus remains after diffusion heat treatment. This results in the occurrence of connection resistance at a magnetic field of 0.5 T, which makes the formation of a superconducting connection difficult.

In the Nb₃Sn superconducting wire prepared by the bronze process, although the method of forming a superconducting connection is established, the properties of the superconducting wire reach their limits. It is thus difficult to achieve further reductions in cost and delivery time.

The present invention was accomplished response to the above circumstances. It is an object of the present invention to provide a Nb₃Sn superconducting wire prepared by an internal Sn process, a precursor for producing the superconducting wire, and a useful method for producing the precursor, the Nb₃Sn superconducting wire having a minimal electrical resistance when superconducting wires are connected to each other, being able to be applied to an NMR magnet, and having excellent critical current density (Jc) properties.

In order to achieve the objects, according to an aspect of the present invention, a precursor for producing a Nb₃Sn superconducting wire by an internal Sn process, the precursor includes a bundle of a plurality of single-element wires each including a Cu or Cu-based alloy matrix, a plurality of Nb or Nb-based alloy filaments, at least one Sn or Sn-based alloy core, the plurality of the Nb or Nb-based alloy filaments and the at least one Sn or Sn-based alloy core being arranged in the Cu or Cu-based alloy matrix, an inner diffusion barrier layer arranged around the periphery of the Cu or Cu-based alloy matrix, the inner diffusion barrier layer being composed of Nb or a Nb-based alloy, and a Cu or Cu-based alloy layer arranged around the periphery of the inner diffusion barrier layer; an outer diffusion barrier layer arranged around the periphery of the bundle of the plurality of the single-element wires, the outer diffusion barrier layer being composed of Nb, a Nb-based alloy, Ta, a Ta-based alloy, or a combination thereof; and a stabilizing copper layer arranged around the periphery of the outer diffusion barrier layer.

The precursor for producing a Nb₃Sn superconducting wire preferably has a structure in which (a) a plurality of Sn or Sn-based alloy filaments are embedded in the Cu or Cu-based alloy layer provided between the bundle of the plurality of the single-element wires and the outer diffusion barrier layer and/or between the individual single-element wires, in which the Sn or Sn-based alloy filaments are embedded in such a manner that a Cu-Sn alloy formed by reaction of the Cu or Cu-based alloy layer and the Sn or Sn-based alloy filaments has a Sn content of 13% to 38% by mass after diffusion heat treatment. Furthermore, the precursor for producing a Nb₃Sn superconducting wire preferably has a structure in which (b) the ratio (D/d) of the thickness D of the inner diffusion barrier layer to the diameter d of each of the Nb or Nb-based alloy filaments in each of the single-element wires is in the range of 0.1 to 1.0.

A Nb₃Sn superconducting wire having an intended superconducting properties (critical current density Jc) is produced by subjecting one of the above-described precursors for producing superconducting wires to diffusion heat treatment.

A method for producing the precursor for producing a Nb₃Sn superconducting wire described above may include the steps of forming a metal layer inside a cylindrical stabilizing copper layer, the metal layer constituting the outer diffusion barrier layer, disposing a Cu or Cu-based alloy layer inside the metal layer to form a hollow billet, subjecting the hollow billet to hot hollow extrusion to form a cylindrical complex, inserting a bundle of the plurality of the single-element wires into the cylindrical complex, and subjecting the resulting cylindrical complex including the single-element wires to wire drawing.

In the precursor for producing a superconducting wire according to the present invention, the single-element wire includes the inner diffusion barrier layer composed of Nb or a Nb-based alloy. The outer diffusion barrier layer is arranged around the periphery of the bundle of the plurality of the single-element wires, the outer diffusion barrier layer being composed of Nb, a Nb-based alloy, Ta, or a Ta-based alloy, or a combination thereof. Thus, the inner diffusion barrier layers composed of Nb or the Nb-based alloy react effectively to form Nb₃Sn. The stabilizing copper layer is not contaminated with Sn by diffusion heat treatment. It is possible to make a connection between the superconducting wires at a minimal connection resistance. The Nb₃Sn superconducting wire prepared by subjecting the precursor for producing a superconducting wire according to the present invention to diffusion heat treatment has excellent superconducting properties compared with those of superconducting wires prepared by the bronze process. Thus, the Nb₃Sn superconducting wire contributes to reductions in the size and cost of a magnet, the cost of the wire, and delivery time.
Fig. 1 is a schematic cross-sectional view illustrating an example of the structure of a precursor for producing a superconducting wire (single-element wire) by an internal Sn process;
Fig. 2 is a schematic cross-sectional view illustrating another example of the structure of a precursor for producing a superconducting wire (single-element wire) by an internal Sn process;
Fig. 3 is a schematic cross-sectional view illustrating an example of the structure of a precursor for producing a superconducting wire (multi-element wire) by an internal Sn process;
Fig. 4 is a schematic cross-sectional view illustrating another example of the structure of a precursor for producing a superconducting wire (multi-element wire) by an internal Sn process;
Fig. 5 is a schematic cross-sectional view illustrating an example of the structure of a single-element wire according to the present invention;
Fig. 6 is a schematic cross-sectional view illustrating an example of the structure of a cylindrical complex according to the present invention;
Fig. 7 is a schematic cross-sectional view illustrating an example of the structure of a precursor for producing a superconducting wire (double-barrier multi-element wire) according to the present invention, the precursor being prepared by combining the single-element wires shown in Fig. 5 and the cylindrical complexes shown in Fig. 6;
Fig. 8 is a schematic cross-sectional view illustrating another example of the structure of a single-element wire according to the present invention;
Fig. 9 is a schematic cross-sectional view illustrating an example of the structure of a precursor for producing a superconducting wire (double-barrier multi-element wire) according to the present invention, the precursor being prepared by combining the single-element wires shown in Fig. 8 and the cylindrical complexes shown in Fig. 6;
Fig. 10 is a schematic cross-sectional view illustrating another example of the structure of a precursor for producing a superconducting wire (double-barrier multi-element wire) according to the present invention, the precursor being prepared by combining the single-element wires shown in Fig. 5, Sn-based metal cores, and the cylindrical complexes shown in Fig. 6;
Fig. 11 is a schematic cross-sectional view illustrating a connection between a Nb₃Sn superconducting wire according to the present invention and a superconducting wire of a superconducting magnet for evaluating connection resistance; and
Fig. 12 is a schematic diagram illustrating a circuit for evaluating connection resistance, the circuit including a U-shaped connection sample using a Nb₃Sn superconducting wire according to the present invention, a persistent current switch, and a superconducting coil.

The inventors have conducted studies from various perspectives to achieve the above objects of the present invention, and have found that a structure (hereinafter; the structure may be referred to as a "double-barrier-type structure") including a bundle of a plurality of single-element wires each having a diffusion barrier layer (hereinafter, also referred to as an "inner diffusion barrier layer") composed of Nb or a Nb-based alloy, and an outer diffusion barrier layer arranged around the periphery of the bundle of the plurality of the single-element wires, the outer diffusion barrier layer being composed of Nb, a Nb-based alloy, Ta, or a Ta-based alloy, or a combination thereof, eliminates contamination of the stabilizing copper layer with Sn when the stabilizing copper layer is removed after diffusion heat treatment and then superconducting connection is made, so that the superconducting wires can be connected to each other at a minimal connection resistance. The findings have led to the completion of the present invention. The precursor for producing a superconducting wire (hereinafter, may be simply referred to as a "precursor") according to the present invention will be described on the basis of the drawings.

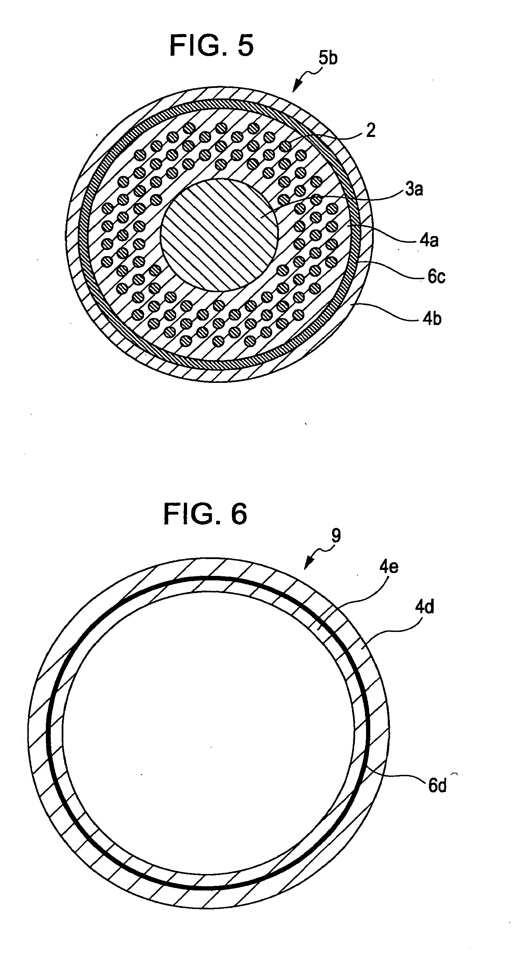

Fig. 5 is a schematic cross-sectional view illustrating an example of the structure of a single-element wire according to the present invention. This structure (single-element wire 5b) includes the Cu matrix 4a having the Nb-based metal filaments 2 (filaments composed of Nb or a Nb-based alloy) and the Sn-based metal core 3a (core composed of Sn or a Sn-based alloy), the stabilizing copper layer 4b outside the Cu matrix 4a, and a diffusion barrier layer 6c provided between the Cu matrix 4a and the stabilizing copper layer 4b. Although the basic structure of the single-element wire 5b is the same as that of the precursor 5a shown in Fig. 2, the diffusion barrier layer 6c (inner diffusion barrier layer) arranged in the single-element wire 5b needs to be composed of Nb or a Nb-based alloy. The inner diffusion barrier layer 6c is composed of Nb or a Nb-based alloy in order to allow the entire inner diffusion barrier layer 6c to convert into a Nb₃Sn phase. The Nb-based alloy used for the inner diffusion barrier layer 6c may contain Ta as an alloy element to the extent that the Nb-based alloy is not impaired by Ta, i.e., the Nb-based alloy may contain Ta in an amount of about 5% to 10% by mass.

In the single-element wire 5b, the ratio (D/d) of the thickness D of the inner diffusion barrier layer 6c to the diameter d of each of the Nb or Nb-based alloy filaments 2 is preferably in the range of 0.1 to 1.0. A ratio (D/d) exceeding 1.0 results in the inner diffusion barrier layer 6c having an excessively large thickness, so that unreacted Nb remains after diffusion heat treatment, thereby leading to the occurrence of connection resistance. A ratio (D/d) of less than 0.1 results in the fracture of the inner diffusion barrier layer 6c during a reduction process. The lower limit of the ratio (D/d) is preferably about 0.3. The upper limit of the ratio (D/d) is preferably about 0.5. The inner diffusion barrier layer 6c can be formed by winding a sheet member composed of Nb or a Nb-based alloy around the periphery of the Cu matrix 4a.

Fig. 6 is a schematic cross-sectional view illustrating an example of the structure of a cylindrical complex according to the present invention. The cylindrical complex 9 is formed by forming a metal layer inside the cylindrical stabilizing copper layer 4d, the metal layer constituting an outer diffusion barrier layer 6d (see Fig. 7), disposing a Cu or Cu-based alloy layer 4e inside the metal layer to form a hollow billet, and subjecting the hollow billet to hot hollow extrusion. In the cylindrical complex 9, the material of the metal layer constituting the outer diffusion barrier layer 6d is Nb, a Nb-based alloy, Ta, a Ta-based alloy, or a combination thereof (for example, two-layer structure of a Nb layer and a Ta layer).

The outer diffusion barrier layer 6d arranged in the cylindrical complex 9 may be composed of Ta or a Ta-based alloy in view of preventing the diffusion of Sn into the stabilizing copper layer (barrier effect) during diffusion heat treatment. From the viewpoint of achieving good balance between the barrier effect and wire drawing, the outer diffusion barrier layer 6d preferably has a thickness of about 5 to 30 µm after wire drawing. The outer diffusion barrier layer 6d can be formed by attaching a sheet member (e.g., a Nb sheet) to the inner side of the stabilizing copper layer 4d.

A precursor for producing a superconducting wire (double-barrier multi-element wire) 9a shown in Fig. 7 can be formed by inserting a bundle of a plurality of the single-element wires 5b shown in Fig. 5 into the cylindrical complex 9 and subjecting the resulting cylindrical complex 9 including the single-element wires 5b to wire drawing (for example, cold wire drawing). In this structure, the Cu or Cu-based alloy layer 4e in the cylindrical complex 9 constitutes the periphery of the Cu matrix 4c of the precursor 9a for producing a superconducting wire. In the case where the precursor 9a for producing a superconducting wire shown in Fig. 7 is produced, the single-element wires 5b may be partially replaced with a Cu or Cu-based metal wire (dummy member) in order to prevent disconnection during wire drawing.

Fig. 8 is a schematic cross-sectional view illustrating another example of the structure of the single-element wire according to the present invention. This structure is formed as follows: The Nb-based metal filament 2 (filament composed of Nb or Nb-based alloy) is inserted into a Cu pipe. The resulting Cu pipe including the Nb-based metal filament 2 is subjected to wire drawing to form a Cu/Nb composite single-core wire. A Sn-based metal filament 3b (filament composed of Sn or a Sn-based alloy) is inserted into a Cu pipe to form a Cu/Sn composite single-core wire. A bundle of a plurality of the Cu/Nb composite single-core wire and the Cu/Sn composite single-core wire is inserted into the cylindrical complex 9 shown in Fig. 6. The resulting cylindrical complex 9 including the bundle is subjected to wire drawing (for example, cold wire drawing) to form a single-element wire 5c shown in Fig. 8. In this structure, the Cu or Cu-based alloy layer 4e in the cylindrical complex 9 constitutes the periphery of the Cu matrix 4a in the single-element wire (precursor for producing a superconducting wire) 5c.

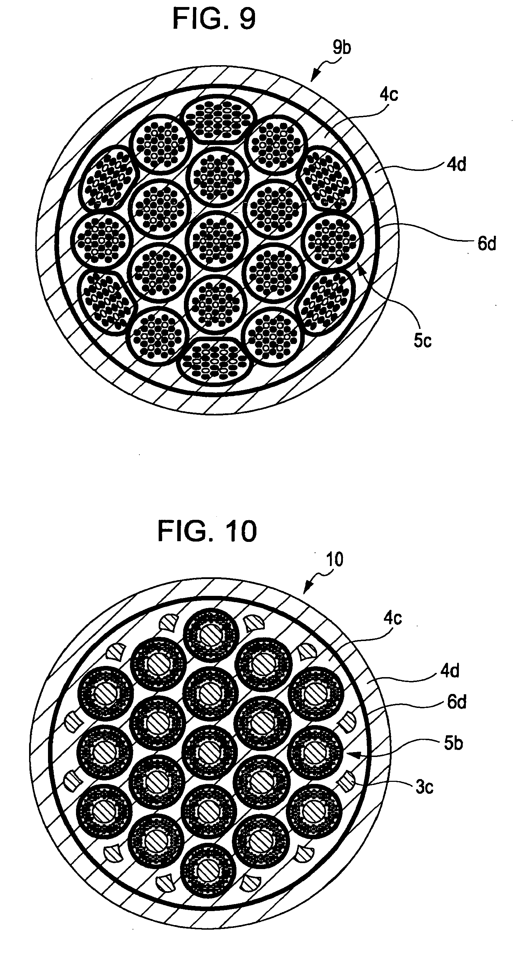

A precursor 9b for producing a superconducting wire (double-barrier multi-element wire) shown in Fig. 9 can be formed by inserting a bundle of a plurality of the single-element wires 5c shown in Fig. 8 into the cylindrical complex 9 shown in Fig. 6 and subjecting the resulting cylindrical complex 9 including the bundle to wire drawing (for example, cold wire drawing). In this structure, the Cu or Cu-based alloy layer 4e in the cylindrical complex 9 (Fig. 6) constitutes the periphery of the Cu matrix 4c in the double-barrier multi-element wire 9b (precursor for producing a superconducting wire). Also in the case where the precursor 9b for producing a superconducting wire shown in Fig. 9 is produced, the single-element wires 5c may be partially replaced with a Cu or Cu-based metal wire (dummy member) in order to prevent disconnection during wire drawing.

With respect to the Nb₃Sn superconducting wires prepared by subjecting known multi-element wires shown in Figs. 3 and 4 to diffusion heat treatment, the stabilizing copper layer is removed after heat treatment, and then the superconducting wires are connected. In the case where the diffusion barrier layer 6b or 6a (Fig. 2) is composed of Ta, Ta or a Ta-Sn compound formed by reaction of Ta and Sn is in the normal conduction mode to generate resistance in a magnetic field applied to the connection of the superconducting wires. Even in the case where the diffusion barrier layer 6b or 6a is composed of Nb, in order to prevent the diffusion of Sn into the stabilizing copper layer 4b or 4d, the diffusion barrier layer 6b or 6a cannot be allowed to react completely, so that an unreacted Nb layer remains, resulting in normal conduction to generate resistance.

In contrast, in each of the precursors (double-barrier multi-element wires) 9a and 9b according to the present invention shown in Figs. 7 and 9, diffusion heat treatment after removal of the stabilizing copper layer 4d and outer diffusion barrier layer 6d allows each of the inner diffusion barrier layers 6c to react completely with Sn to form a Nb₃Sn phase because the inner diffusion barrier layers 6c in the single-element wires 5b and 5c each have a small thickness. Although Sn diffuses into the Cu or Cu-based alloy 4a, a Cu-Sn alloy phase having a high Sn content is not formed. The Nb-based metal filaments 2 inside the Cu or Cu-based alloy 4a are not oxidized. Each of the inner diffusion barrier layers 6c that have been converted into Nb₃Sn can be easily exposed by simply removing the Cu or Cu-based alloy 4a, thereby resulting in superconducting connection without electrical resistance. The outer diffusion barrier layer 6d is present except for a portion where the stabilizing copper layer 4d and outer diffusion barrier layer 6d are removed; hence, the stabilizing copper layer 4d is not contaminated with Sn.

To improve critical current density Jc properties, a precursor (double-barrier multi-element wire) 10 having a structure in which a plurality of Sn or Sn-based alloy filaments 3c are embedded in the Cu or Cu-based alloy layer 4c between the bundle of the plurality of the single-element wires 5b (Fig. 3) and the outer diffusion barrier layer 6d as shown in Fig. 10 may be used as another embodiment of the present invention. The precursor 10 having the above structure can be produced by combining the single-element wire 5b shown in Fig. 5, the cylindrical complex 9 shown in Fig. 6, and the Cu/Sn composite single-core wire described above.

Also in the case where the precursor (double-barrier multi-element wire) 10 for producing a superconducting wire shown in Fig. 10 is produced, the single-element wires 5c may be partially replaced with a Cu or Cu-based metal wire (dummy member) in order to prevent disconnection during wire drawing. Fig. 10 shows a structure in which the plurality of the Sn or Sn-based alloy filaments 3c are embedded in the Cu or Cu-based alloy layer 4c between the bundle of the plurality of the single-element wires 5b and the outer diffusion barrier layer 6d. A structure in which the plurality of the Sn or Sn-based alloy filaments 3c are embedded in the Cu or Cu-based alloy layer may be used in place of or together with the structure described above. Furthermore, in the precursor for producing a superconducting wire (double-barrier multi-element wire) shown in Fig. 10, the single-element wires 5c shown in Fig. 8 may be used in place of the single-element wires 5b shown in Fig. 5.

In any case, in the case where the plurality of the Sn or Sn-based alloy filaments 3c are embedded in the Cu or Cu-based alloy layer, the Sn or Sn-based alloy filaments need to be embedded in such a manner that a Cu-Sn alloy formed by reaction of the Cu or Cu-based alloy layer and the Sn or Sn-based alloy filaments has a Sn content of 13% to 38% by mass after diffusion heat treatment.

In the precursor (double-barrier multi-element wire) 10 according to the present invention shown in Fig. 10, diffusion heat treatment after removal of the stabilizing copper layer 4d and the outer diffusion barrier layer 6d allows Sn in the Sn or Sn-based alloy filaments 3c arranged around the periphery of the bundle of the single-element wires 5b and/or arranged between the single-element wires 5b to diffuse into the Cu or Cu-based alloy layer 4c, thereby forming a Cu-Sn alloy phase having a Sn content of 13% to 38% by mass. Sn in the Sn-based metal core 3a in each of the single-element wires 5b diffuses by diffusion heat treatment to easily convert the entire diffusion barrier layer (inner diffusion barrier layer 6c) in each of the single-element wire 5b into a Nb₃Sn phase, compared with the precursors 9a and 9b shown in Figs. 7 and 9. In this structure, the ε phase and the η phase, which are Cu-Sn alloy phases each having a high Sn content, are not formed. The Nb-based metal filaments 2 inside thereof are not oxidized. The inner diffusion barrier layers 6c that have been converted into Nb₃Sn can be easily exposed by simply removing the Cu or Cu-based alloy 4a, thereby resulting in superconducting connection without electrical resistance.

In the precursor for producing a superconducting wire according to the present invention, the ratio (S₀/S₁) of the total cross-sectional area S₀ of a region of the copper or copper-based alloy (Cu matrix) provided between the inner diffusion barrier layer in each of the single-element wires and the outer diffusion barrier layer to the total cross-sectional area S₁ of the inner diffusion barrier layers and regions inside the inner diffusion barrier layers is preferably in the range of 0.2 to 2.0. A ratio (S₀/S₁) of less than 0.2 results in difficulty in leaving the Cu layer when the outer diffusion barrier layer is removed. A ratio (S₀/S₁) exceeding 2.0 reduces the area of the Nb₃Sn phase, thereby degrading the critical current density Jc properties. A ratio (S₀/S₁) within the above range results in a superconducting wire having a high critical current density Jc and satisfactory connection performance. The ratio (S₀/S₁) is more preferably from 0.2 to less than 1.0 and still more preferably 0.2 to about 0.5.

A Nb₃Sn superconducting wire prepared by subjecting any precursor according to the present invention described above to diffusion heat treatment has excellent critical current density Jc properties compared with those of superconducting wires prepared by the bronze process, thereby contributing to reductions in the size and cost of an NMR magnet, the cost of the wire, and delivery time.

In the present invention, a Nb₃Sn superconducting wire having excellent superconducting properties (critical current density Jc) can be produced by subjecting such a precursor described above to diffusion heat treatment (usually from 200°C to less than about 800°C) including a heat treatment step of forming bronze. Specifically, the heat treatment step of forming bronze (diffusing Sn into Cu) is performed in the range of 180°C to 600°C. Then a heat treatment step of forming Nb₃Sn is performed in the range of 650°C to 750°C for about 100 to about 300 hours. The heat treatment step of forming bronze may be multi-step heat treatment including substeps of heating the precursor at 180°C to 200°C for about 50 hours, at about 340°C for about 50 hours, and at about 550°C for 50 to 100 hours, for example.

The present invention will be described in further detail below with reference to examples. However, the present invention is not limited to these examples and may be properly modified within the scopes of the preceding description and the following description, and all such modifications are included in the technical scope of the present invention.

### EXAMPLES

### EXAMPLE 1

A precursor (double-barrier multi-element wire), having a cross-sectional shape shown in Fig. 7, for producing a superconducting wire was produced by the following procedure. A Nb core having an external diameter of 28 mm was inserted into a Cu pipe having an external diameter of 33.8 mm and an internal diameter of 29 mm. The resulting pipe was subjected to a reduction process to form a Cu/Nb composite single-core wire having a hexagonal sectional shape (hexagon opposite side distance: 4.3 mm). The resulting wire was corrected and cut into a length of 400 mm. In this case, the resulting Nb core had a diameter of 3.87 mm.

A Cu hollow billet including a Cu outer cylinder having an external diameter of 143 mm and internal diameter of 128 mm and a Cu inner cylinder having an external diameter of 70 mm and internal diameter of 61 mm was prepared. A Nb sheet having a thickness of 0.2 mm was attached to the inner surface of the Cu outer cylinder of the Cu hollow billet to form a diffusion barrier layer (Nb barrier layer) in such a manner that the Nb barrier layer had a thickness (1.86 mm) 0.48 times the diameter of the Nb core.

A bundle of 480 Cu/Nb composite single-core wires described above was provided around the Cu inner cylinder and inserted into the Cu outer cylinder having the Nb barrier layer. The resulting Cu hollow billet was covered and evacuated, followed by welding of the cover. The resulting billet was subjected to hot hollow extrusion. A Sn alloy core containing 2% by mass Ti was inserted into the Cu inner cylinder. The resulting composite was subjected to wire drawing to form a single-element wire having a hexagonal sectional shape (hexagon opposite side distance: 4.0 mm) (see Fig. 5).

A Nb sheet having a thickness of 0.2 mm was wound around a Cu inner cylinder having an external diameter of 68 mm and internal diameter of 51 mm of another Cu hollow billet to form an outer diffusion barrier layer. The resulting Cu inner cylinder was inserted into a Cu outer cylinder having an external diameter of 143 mm and internal diameter of 88 mm. The resulting Cu hollow billet was covered and evacuated, followed by welding of the cover. The resulting billet was subjected to hot hollow extrusion and then drawing to form a composite pipe having an external diameter of 33.8 mm and internal diameter of 29 mm as shown in Fig. 6.

A bundle of 37 single-element wires described above was inserted into the composite pipe. The resulting composite was subjected to wire drawing to form a precursor (double-barrier multi-element wire) for producing a superconducting wire, the precursor having an external diameter of 1.0 mm (see Fig. 7). In this precursor, the ratio (S₀/S₁) of the total cross-sectional area S₀ of a region of the copper or copper-based alloy (Cu matrix) provided between the inner diffusion barrier layer in each of the single-element wires and the outer diffusion barrier layer to the total cross-sectional area S₁ of the inner diffusion barrier layers and regions inside the inner diffusion barrier layers was measured by image processing of a photograph of a cross section taken with a metallurgical microscope or a scanning electron microscope (SEM) and determined to be 0.25. The thickness of the outer diffusion barrier layer after wire drawing was set to 11 µm.

The resulting precursor, having an external diameter of 1.0 mm, for producing a superconducting wire was subjected to heat treatment (diffusion heat treatment) at 550°C for 100 hours and then 670°C for 100 hours to form a Nb₃Sn superconducting wire. The critical current density Jc and the magnetic field attenuation rate of the resulting Nb₃Sn superconducting wire were measured as described below. Measurement of Critical Current Density Jc

In liquid helium (temperature of 4.2 K), an electric current was supplied to a sample (superconducting wire) under an external magnetic field of 16 T to measure a generated voltage by a four-terminal method. An electric current (critical current Ic) was measured when an electrical field of 0.1 µV/cm was produced. The measured current value was divided by the entire sectional area of the wire to determine the critical current density Jc. Measurement of Magnetic Field Attenuation Rate

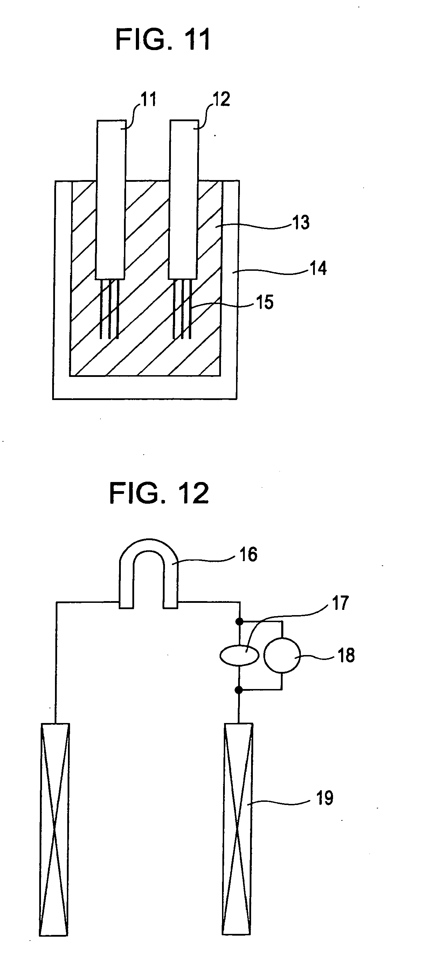

A circuit for evaluating connection resistance shown in Fig. 12 was formed. Fig. 12 shows a U-shaped connection sample 16 made of a Nb₃Sn superconducting wire produced, a persistent current switch 17, a power supply 18, and superconducting coils 19. After the U-shaped connection sample 16 was subjected to heat treatment, as shown in Fig. 11, Cu coverings of ends 12 of the U-shaped connection sample 16 were removed to expose Nb₃Sn filaments 15. Both ends 12 of the U-shaped connection sample 16 were connected to superconducting wires 11 of superconducting magnets (superconducting coils 19) with a superconducting intermediate material 13 (for example, a Pb-based alloy). A magnetic field attenuation rate of the center of each of the superconducting coils 19 was measured while the connections were maintained at a temperature of 4.2 K and a magnetic field of 0.5 T. In this case, the attenuation rate (ppm/h) was determined by measuring a change in resonance frequency (corresponding to a magnetic field) with an NMR probe. Fig. 11 also shows a Cu-based vessel 14.

### EXAMPLE 2

A precursor (double-barrier multi-element wire), having a cross-sectional shape shown in Fig. 9, for producing a superconducting wire was produced by the following procedure. A Cu/Nb composite single-core wire with a hexagonal sectional shape (hexagon opposite side distance: 2.0 mm) was produced as in EXAMPLE 1. The resulting wire was corrected and cut into a length of 5 m. A Sn alloy core containing 2% by mass Ti was inserted into a Cu pipe having an external diameter of 24.0 mm and an internal diameter of 21.0 mm. The resulting pipe composite was subjected to reduction process to form a Cu/Sn composite single-core wire having a hexagonal sectional shape (hexagon opposite side distance: 2.0 mm). The resulting wire was corrected and cut into a length of 5 m. Furthermore, a cylindrical complex, having an external diameter of 33.8 mm and an internal diameter of 29 mm, shown in Fig. 6 was produced as in EXAMPLE 1.

A bundle in which 114 Cu/Nb composite single-core wires were combined with 49 Cu/Sn composite single-core wires was inserted into the cylindrical complex. The resulting composite was subjected to wire drawing to form a single-element wire having a hexagonal sectional shape (hexagon opposite side distance: 4.0 mm). The resulting wire was corrected and cut into a length of 5 m. In this case, the Nb barrier layer had a thickness 0.49 times the diameter of the Nb core.

A cylindrical complex, having an external diameter of 33.8 mm and an internal diameter of 29 mm, shown in Fig. 6 was produced as in EXAMPLE 1. A bundle of 37 single-element wires described above was inserted into the cylindrical complex. The resulting complex was subjected to wire drawing to form a precursor (double-barrier multi-element wire) for producing a superconducting wire, the precursor having an external diameter of 1.0 mm (see Fig. 9). In this precursor, the ratio (S₀/S₁) was 0.3. The thickness of the outer diffusion barrier layer after wire drawing was set to 11 µm.

The resulting precursor, having an external diameter of 1.0 mm, for producing a superconducting wire was subjected to heat treatment (diffusion heat treatment) at 550°C for 100 hours and then 670°C for 100 hours to form a Nb₃Sn superconducting wire. The critical current density Jc and the magnetic field attenuation rate of the resulting Nb₃Sn superconducting wire were measured as in EXAMPLE 1.

### EXAMPLE 3

A precursor (double-barrier multi-element wire), having a cross-sectional shape shown in Fig. 10, for producing a superconducting wire was produced by the following procedure. A single-element wire with a hexagonal sectional shape (hexagon opposite side distance: 4.0 mm) was produced as in EXAMPLE 1. The wire was corrected and cut into a length of 5 m. The Nb barrier layer of the single-element wire was set so as to have a thickness 1.0 time the diameter of the Nb core.

A cylindrical complex, having an external diameter of 33.8 mm and an internal diameter of 29 mm, shown in Fig. 6 was produced as in EXAMPLE 1. A bundle of 37 single-element wires described above was inserted into the cylindrical complex. Then 18 Cu/Sn complex single-core wires described in EXAMPLES 1 and 2 were inserted into a gap between the cylindrical complex and the single-element wires. The resulting complex was subjected to wire drawing to form a precursor (double-barrier multi-element wire) for producing a superconducting wire, the precursor having an external diameter of 1.0 mm (see Fig. 10). In this precursor, the ratio (S₀/S₁) was 0.3. The thickness of the outer diffusion barrier layer after wire drawing was set to 11 µm.

The resulting precursor, having an external diameter of 1.0 mm, for producing a superconducting wire was subjected to heat treatment (diffusion heat treatment) at 550°C for 100 hours and then 670°C for 100 hours to form a Nb₃Sn superconducting wire. The critical current density Jc and the magnetic field attenuation rate of the resulting Nb₃Sn superconducting wire were measured as in EXAMPLE 1.

### COMPARATIVE EXAMPLE 1

A precursor (multi-element wire), having a sectional shape shown in Fig. 3, for producing a superconducting wire was produced by the following procedure. A Nb core was inserted into a Cu pipe having an external diameter of 33.8 mm and an internal diameter of 29 mm. The resulting pipe was subjected to a reduction process to form a Cu/Nb composite single-core wire with a hexagonal sectional shape (hexagon opposite side distance: 4.3 mm). The resulting wire was corrected and cut into a length of 400 mm.

A bundle of 480 Cu/Nb composite single-core wires described above was provided around the periphery of a Cu inner cylinder, having an external diameter of 70 mm and an internal diameter of 61 mm, of a Cu hollow billet. The resulting Cu inner cylinder was inserted into a Cu outer cylinder having an external diameter of 143 mm and an internal diameter of 128 mm. The Cu hollow billet was covered and evacuated, followed by welding of the cover. The resulting billet was subjected to hot hollow extrusion. A Sn alloy core containing 2% by mass Ti was inserted into the Cu inner cylinder. The resulting composite was subjected to wire drawing to form a single-element wire having a hexagonal sectional shape (hexagon opposite side distance: 3.9 mm). The wire was corrected and cut into a length of 5 m.

A bundle of 37 single-element wires described above was inserted into a Cu pipe, having an external diameter of 33.8 mm and an internal diameter of 29 mm, provided with a Nb sheet attached to the inner surface of the Cu pipe. The resulting pipe was subjected to wire drawing to form a precursor (multi-element wire) for producing a superconducting wire, the precursor having a diameter of 1.0 mm (see Fig. 3). In this precursor, the ratio (S₀/S₁) was 0.08.

The resulting multi-element wire having an external diameter of 1.0 mm was subjected to heat treatment (diffusion heat treatment) at 550°C for 100 hours and then 670°C for 100 hours to form a Nb₃Sn superconducting wire. The critical current density Jc and the magnetic field attenuation rate of the resulting Nb₃Sn superconducting wire were measured as described below.

### COMPARATIVE EXAMPLE 2

A precursor (multi-element wire), having a sectional shape shown in Fig. 4, for producing a superconducting wire was produced by the following procedure. A single-element wire produced as in EXAMPLE 1 was subjected to wire drawing to form a single-element wire having a hexagonal sectional shape (hexagon opposite side distance: 4.0 mm). The wire was corrected and cut into a length of 5 m. In this case, the Nb barrier layer of the single-element wire had a thickness 1.5 times the diameter of the Nb core.

A bundle of 37 single-element wires described above was inserted into a Cu pipe having an external diameter of 33.8 mm and an internal diameter of 29 mm. The resulting pipe was subjected to wire drawing to form a multi-element wire (precursor for producing a superconducting wire) having a diameter of 1.0 mm.

The resulting precursor, having an external diameter of 1.0 mm, for producing a superconducting wire was subjected to heat treatment (diffusion heat treatment) at 550°C for 100 hours and then 670°C for 100 hours to form a Nb₃Sn superconducting wire. The critical current density Jc and the magnetic field attenuation rate of the resulting Nb₃Sn superconducting wire were measured as in EXAMPLE 1.

Table 1 shows superconducting properties (critical current density Jc and magnetic field attenuation rate in the coil) and the ratio (S₀/S₁) of the superconducting wires produced in EXAMPLES 1 to 3 and COMPARATIVE EXAMPLES 1 and 2. Table 1 also shows the critical current density Jc and the magnetic field attenuation rate of a superconducting wire produced by the bronze process.

**Table 1**

| | Critical current density Jc (A/mm²) | Magnetic field attenuation rate of coil for evaluating connection resistance (ppm/hr) | Area ratio (S₀/S₁) |
|---|---|---|---|
| EXAMPLE 1 | 492 | 0.0080 | 0.25 |
| EXAMPLE 2 | 480 | 0.0071 | 0.3 |
| EXAMPLE 3 | 501 | 0.0050 | 0.3 |
| COMPARATIVE EXAMPLE 1 | 475 | 0.6811 | 0.08 |
| COMPARATIVE EXAMPLE 2 | 503 | 15.008 | - |
| Bronze process | 179 | 0.0050 | 0.2 |

The results clearly demonstrate that in each of EXAMPLES 1 to 3 which satisfy the requirements specified in the present invention, the magnetic field attenuation rate is significantly low, and the critical current density Jc is satisfactory. A critical current density Jc of 300 A/mm² or more and preferably 400 A/mm² or more is necessary. A magnetic field attenuation rate of 0.01 ppm/hr or less is necessary.

## Claims

1. A precursor for producing a Nb₃Sn superconducting wire by an internal Sn process, the precursor comprising:
a bundle of a plurality of single-element wires each including:
a Cu or Cu-based alloy matrix,
a plurality of Nb or Nb-based alloy filaments,
at least one Sn or Sn-based alloy core, the plurality of the Nb or Nb-based alloy filaments and the at least one Sn or Sn-based alloy core being arranged in the Cu or Cu-based alloy matrix,
an inner diffusion barrier layer arranged around the periphery of the Cu or Cu-based alloy matrix, the inner diffusion barrier layer being composed of Nb or a Nb-based alloy, and
a Cu or Cu-based alloy layer arranged around the periphery of the inner diffusion barrier layer;
an outer diffusion barrier layer arranged around the periphery of the bundle of the plurality of the single-element wires, the outer diffusion barrier layer being composed of Nb, a Nb-based alloy, Ta, a Ta-based alloy, or a combination thereof; and
a stabilizing copper layer arranged around the periphery of the outer diffusion barrier layer.

2. The precursor for producing a Nb₃Sn superconducting wire according to claim 1, further comprising:
a plurality of Sn or Sn-based alloy filaments embedded in the Cu or Cu-based alloy layer provided between the bundle of the plurality of the single-element wires and the outer diffusion barrier layer and/or between the individual single-element wires,
wherein the Sn or Sn-based alloy filaments are embedded in such a manner that a Cu-Sn alloy formed by reaction of the Cu or Cu-based alloy layer and the Sn or Sn-based alloy filaments has a Sn content of 13% to 38% by mass after diffusion heat treatment.

3. The precursor for producing a Nb₃Sn superconducting wire according to claim 1 or 2, wherein the ratio (D/d) of the thickness D of the inner diffusion barrier layer to the diameter d of each of the Nb or Nb-based alloy filaments in each of the single-element wires is in the range of 0.1 to 1.0.

4. The precursor for producing a Nb₃Sn superconducting wire according to anyone of claims 1 to 3, wherein the ratio (S₀/S₁) of the total cross-sectional area S₀ of a region of the copper or copper-based alloy provided between the inner diffusion barrier layer in each of the single-element wires and the outer diffusion barrier layer to the total cross-sectional area S₁ of the inner diffusion barrier layers and regions inside the inner diffusion barrier layers is in the range of 0.2 to 2.0.

5. A Nb₃Sn superconducting wire comprising:
a Nb₃Sn superconducting phase formed by subjecting the precursor for producing a superconducting wire according to anyone of claims 1 to 4 to diffusion heat treatment.

6. A method for producing the precursor for producing a Nb₃Sn superconducting wire according to anyone of claims 1 to 4, the method comprising the steps of:
forming a metal layer inside a cylindrical stabilizing copper layer, the metal layer constituting the outer diffusion barrier layer;
disposing a Cu or Cu-based alloy layer inside the metal layer to form a hollow billet;
subjecting the hollow billet to hot hollow extrusion to form a cylindrical complex;
inserting a bundle of the plurality of the single-element wires into the cylindrical complex; and
subjecting the resulting cylindrical complex including the single-element wires to wire drawing.
